# EUROPÄISCHE PATENTANMELDUNG

(11) **EP 1 253 647 A2**
(43) Veröffentlichungstag der Anmeldung: **30.10.2002**
(21) Anmeldenummer: 02100409.8
(22) Anmeldetag: 25.04.2002
(51) Int. Cl.: H01L 29/51

(54) **Dielektrikum für ein Halbleiterbauelement**

(30) Priorität: 27.04.2001 DE 10120877
(71) Anmelder: Philips Corporate Intellectual Property GmbH, 20099 Hamburg (DE); Koninklijke Philips Electronics N.V., 5621 BA Eindhoven (NL)
(72) Erfinder: Klee, Mareike, c/o Philips Corp. Intel. Prop.GmbH, 52066, Aachen (DE); Löbl, Hans-Peter,c/o Philips Corp.Intel.Prop. GmbH, 52066, Aachen (DE)
(74) Vertreter: Volmer, Georg, Dipl.-Ing.

(57) **Zusammenfassung**

Die Erfindung betrifft eine Anordnung mit einem Halbleiterbauelement sowie ein Verfahren zum Herstellen der Anordnung. Bei dem Halbleiterbauelement ist ein Steueranschluss (9) mittels einer Dielektrikumsschicht (11) von einem Substrat (1) elektrisch isoliert. Die Dielektrikumsschicht (11) ist aus Aluminiumnitrid gebildet.

## Beschreibung

Die Erfindung liegt auf dem Gebiet von Halbleiterbauelementen, bei denen ein Steueranschluss mittels einer Dielektrikumsschicht von einem Halbleitersubstrat elektrisch isoliert ist.

Solche Halbleiterbauelemente weisen in der Regel drei Anschlüsse auf, die als Gate (Steueranschluss), Source (Quelle) und Drain (Senke) bezeichnet werden. Es sind einzelne Halbleiterbauelemente, beispielsweise Transistoren, sowie Anordnungen mit mehreren Halbleiterbauelementen bekannt. Hierbei handelt es sich in der Regel um Feldeffekttransistoren, bei denen mit einer zwischen dem Steueranschluss und der Quelle angelegten Steuerspannung die Leitfähigkeit der Senke-Quelle-Strecke beeinflusst wird, ohne dass ein Steuerstrom fließt, das heißt die Steuerung erfolgt leistungslos. Bei heutigen Halbleiterbauelementen dieser Art ist der Steueranschluss in der Regel aus Siliziumdioxid (SiO₂) gebildet.

Mit Hilfe einer zunehmenden Miniaturisierung der Transistoren wird versucht, eine hohe Transistordichte in den Halbleiterbauelementen zu erreichen. Dieses hat zur Folge, dass eine Dielektrikumsschicht, mittels der der Steueranschluss von dem Substrat elektrisch isoliert ist, höhere Kapazitätsdichten aufweist. Höhere Kapazitätsdichten sind notwendig, um bei den infolge der Miniaturisierung auftretenden kleinen Abmessungen eine ausreichende Ladungsdichte zu erreichen. Zu diesem Zweck ist bei bekannten Halbleiterbauelementen vorgesehen, die Dielektrikumsschichten aus SiO₂ dünner zu gestalten. Es werden Dielektrikumsschichten von ca. 4 nm verwendet. Zukünftig sollen Dielektrikumsschichten mit einer Dicke von etwa 2 bis 3 nm verwendet werden. Bei solchen Dielektrikumsschichten werden steigende Tunnelströme zum Problem.

Um diesem Verhalten der Halbleiterbauelemente entgegenzuwirken, wurden oxidische Verbindungen, wie ZrO₂, TiO₂ oder Lanthansilikate vorgeschlagen. Diese Verbindungen haben jedoch den Nachteil, dass bei Abscheidung auf Silizium eine SiO₂-Zwischen-schicht zwischen dem Steueranschluss und der Dielektrikumsschicht mit hoher Dielektrizitätskonstante gebildet werden kann. Hierdurch wird die gespeicherte Ladung deutlich gesenkt.

Aufgabe der Erfindung ist es, eine verbesserte Anordnung mit einem Halbleiterbauelement zu schaffen, bei dem ein Steueranschluss mittels einer Dielektrikumsschicht von einem Substrat elektrisch isoliert ist, wobei die Dielektrikumsschicht eine ausreichende Dielektrizitätskonstante aufweisen soll, um in Verbindung mit dünnen Steueranschlüssen genutzt zu werden.

Diese Aufgabe wird bei einer Anordnung nach dem Oberbegriff des Anspruchs 1 erfindungsgemäß dadurch gelöst, dass die Dielektrikumsschicht aus Aluminiumnitrid gebildet ist.

Ein wesentlicher Vorteil, welcher mit der Erfindung gegenüber dem Stand der Technik erreicht ist, besteht darin, dass eine Dielektrikumsschicht geschaffen ist, deren relative Dielektrizitätskonstante wesentlich höher als die von bekannten Dielektrikumsschichten aus SiO₂ ist. Aluminiumnitrid hat eine hohe Dielektrizitätskonstante von etwa zehn, während SiO₂ eine relative Dielektrizitätskonstante von etwa vier aufweist.

Ein weiterer Vorteil besteht darin, dass die Dielektrikumsschicht aus Aluminiumnitrid thermodynamisch sehr stabil ist, wodurch die Bildung von SiO₂-Zwischenschichten verhindert ist.

Bei zweckmäßigen Weiterbildungen der Erfindung können hohe Dielektrizitätskonstanten auch dadurch erreicht werden, dass die Dielektrikumsschicht mit Silizium, Wasserstoff oder Sauerstoff dotiert ist.

Zum Ausbilden der vorteilhaften Anordnung mit einem Halbleiterbauelement wird beim Herstellen der Anordnung Aluminiumnitrid auf dem Substrat aufgebracht. Hierbei können moderne Dünnschichtverfahren genutzt werden, die als solche bekannt sind, beispielsweise das Sputtern, das Elektronenstrahlverdampfen, das chemische Abschalten aus der Gasphase, die Molekular-Strahl-Epitaxie in sehr dünnen Schichten oder Verfahren zur Abscheidung atomarer oder molekularer Lagen. Bei diesen Verfahren wird das Aluminiumnitrid auf Silizium abgeschieden.

Die Erfindung wird im folgenden anhand eines Ausführungsbeispiels unter Bezugnahme auf eine Zeichnung näher erläutert.

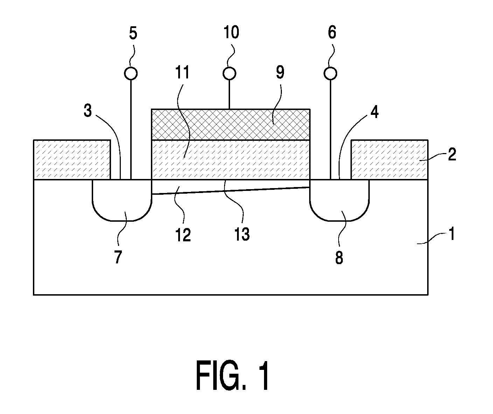

Figur 1 zeigt eine schematische Darstellung eines Feldeffekttransistors. Auf ein Si-Substrat 1 ist eine Isolier- bzw. Dielektrikumsschicht 2 aus Aluminiumnitrid aufgebracht. Im Bereich von Öffnungen 3, 4 in der Isolierschicht 2 sind ein Source- und ein Drain-Anschluss 5, 6 herausgeführt. Der Source- und der Drain-Anschluss 5,6 stehen mit einem Source- bzw. einem Drain-Bereich 7,8 in Verbindung

Ein Gate 9 ist mit einem weiteren Anschluss 10 verbunden. Das Gate 9 ist mit Hilfe eines Abschnitts 11 der Isolierschicht 2 von dem Substrat 1 isoliert. Unterhalb des Abschnitts 11 befindet sich ein Inversionskanal 12. Das Gate ist mit Hilfe des Abschnitts 11 der Isolierschicht 2 von einer Oberfläche 13 des Inversionskanals 12 isoliert.

Die Nutzung von Aluminiumnitrid als Dielektrikumsschicht zum Isolieren des Gate-Bereichs von dem Substrat kann sowohl in Verbindung mit MOSFET-Transistoren als auch mit Sperrschicht-Feldeffekttransistoren genutzt werden.

Die in der vorstehenden Beschreibung, der Zeichnung und den Ansprüchen offenbarten Merkmale der Erfindung können sowohl einzeln als auch in beliebiger Kombination für die Verwirklichung der Erfindung in ihren verschiedenen Ausführungsformen von Bedeutung sein.

## Patentansprüche

1. Anordnung rnit einem Halbleiterbauelement, bei dem ein Steueranschluss (9) mittels einer Dielektrikumsschicht (11) von einem Substrat (1) elektrisch isoliert ist,
**dadurch gekennzeichnet,**
**dass** die Dielektrikumsschicht (11) aus Aluminiumnitrid gebildet ist.

2. Anordnung nach Anspruch 1,
**dadurch gekennzeichnet,**
**dass** die Dielektrikumsschicht (11) mit Silizium dotiert ist.

3. Anordnung nach Anspruch 1,
**dadurch gekennzeichnet,**
**dass** die Dielektrikumsschicht (11) mit Wasserstoff dotiert ist.

4. Anordnung nach Anspruch 1,
**dadurch gekennzeichnet,**
**dass** die Dielektrikumsschicht (11) mit Sauerstoff dotiert ist.

5. Verfahren zum Herstellen einer Anordnung mit einem Halbleiterbauelement, bei dem ein Steueranschluss (9) mittels einer auf einem Substrat (1) aufgebrachten Dielektrikumsschicht (11) von dem Substrat (1) elektrisch isoliert wird,
**dadurch gekennzeichnet,**
**dass** zum Ausbilden der Dielektrikumsschicht (11) Aluminiumnitrid auf dem Substrat (1) aufgebracht wird

6. Verfahren nach Anspruch 5,
**dadurch gekennzeichnet,**
**dass** die Dielektrikumsschicht (11) mit Silizium dotiert wird.

7. Verfahren nach Anspruch 5,
**dadurch gekennzeichnet,**
**dass** die Dielektrikumsschicht (11) mit Wasserstoff dotiert wird

8. Verfahren nach Anspruch 5,
**dadurch gekennzeichnet,**
**dass** die Dielektrikumsschicht (11) mit Sauerstoff dotiert wird

9. Verfahren nach einem der Ansprüche 5 bis 8,
**dadurch gekennzeichnet,**
**dass** die Dielektrikumsschicht (11) mit Hilfe einer der folgenden Technologien auf dem Substrat aufgebracht wird Sputtern, Elektronenstrahlverdampfen, chemisches Abscheiden aus der Gasphase, Molekular-Strahl-Epitaxie, oder Verfahren zur Abscheidung von atomaren oder molekularen Lagen.
